# EUROPEAN PATENT APPLICATION

(11) **EP 4 788 094 A1**
(43) Date of publication of application: **05.08.2026**
(21) Application number: 25799475.6
(22) Date of filing: 16.10.2025
(51) Int. Cl.: H10F 77/20

(54) **PHOTOVOLTAIC MODULE**

(30) Priority: 07.11.2024 CN 202411586844
(71) Applicant: JINKO SOLAR CO., LTD., Shangrao, Jiangxi 334100 (CN); ZHEJIANG JINKO SOLAR CO., LTD., Hainan, Zhejiang (CN)
(72) Inventor: ZHENG, Peiting, Shangrao, Jiangxi 334100 (CN); LI, Huimin, Shangrao, Jiangxi 334100 (CN); XU, Menglei, Shangrao, Jiangxi 334100 (CN); YANG, Jie, Shangrao, Jiangxi 334100 (CN); ZHANG, Xinyu, Shangrao, Jiangxi 334100 (CN)
(74) Representative: Balder IP Law, S.L.
(86) International application number: PCT/CN2025/128105
(87) International publication number: WO 2026/098184

(57) **Abstract**

The present disclosure relates to the field of photovoltaics and provides a photovoltaic module. The photovoltaic module includes: cells, which includes welding regions and collection regions arranged along a first direction; a surface of the cells has a plurality of fingers arranged along a second direction, each finger includes at least two welding fingers located in the welding region and collection fingers located in the collection region, where the welding fingers are arranged along the second direction, and each of the at least two welding fingers is electrically connected to the same collection finger; a connecting member, located on the cells, the connecting member is electrically connected to the plurality of fingers arranged along the second direction, and the connecting member is welded to each welding finger. The photovoltaic module provided by the embodiments of the present disclosure can at least reduce power generation loss.

## Description

### CROSS REFERENCE TO RELATED APPLICATIONS

This application is a continuation of PCT Patent Application No. PCT/CN2025/128105, filed on October 16, 2025, which claims priority to Chinese Patent Application No. 202411586844.9, titled "PHOTOVOLTAIC MODULE," filed on November 7, 2024, each of which are incorporated herein by reference in its entirety.

### TECHNICAL FIELD

Embodiments of the present application relate to the field of photovoltaics, and in particular, to a photovoltaic module.

### BACKGROUND

Solar cells are devices that directly convert light energy into electrical energy through the photovoltaic effect or photochemical effect. A single solar cell cannot generate electricity for direct use. It must be connected in series and parallel via ribbons with several other single cells and strictly encapsulated into a module before use. The solar cell module (also called a solar cell panel) is the core part of a solar power generation system, and also the most important part of the solar power generation system. The function of a solar cell module is to convert solar energy into electricity, which is then either sent to a battery for storage or used to drive a load.

The busbars and fingers on the solar cell are key components that ensure solar conversion efficiency. The busbars are responsible for collecting solar energy, while the fingers increase light absorption and current transmission efficiency. The busbars and fingers work together to ensure maximum absorption and conversion efficiency of solar energy. The busbars are directly connected to the external leads of the cell (i.e., the connecting members) and are the relatively thick parts. The fingers serve to collect current and transmit the current to the busbars, are the relatively thin parts, and are made into narrow, fine fingers to overcome the resistance of the diffusion layer.

However, the front-side fingers (busbars and fingers) block a portion of the silicon wafer. The light energy falling on these fingers cannot be converted into electricity, resulting in waste. Furthermore, the primary component of the paste used to make these fingers is silver, a relatively expensive precious metal, thus also involving cost issues. Based on this, technicians have enabled more and finer connecting members to directly connect to the cell fingers, collecting current while achieving cell interconnection, and eliminating traditional busbars at the cell level, known as "busbar-free" technology. However, there are still many factors affecting the yield and the power generation loss of photovoltaic modules, such as the welding effect and the welding yield between the connecting members and the fingers.

### SUMMARY

The embodiments of the present application provide a photovoltaic module, which is at least beneficial for reducing power generation loss.

According to some embodiments of the present application, an embodiment of the present application provides a photovoltaic module, including: cells, the cells including a welding region and collection regions arranged along a first direction; a surface of the cells having a plurality of fingers arranged along a second direction, each of the fingers including at least two welding fingers located in the welding region and collection fingers located in the collection region, where the welding fingers are arranged along the second direction, and each of the at least two welding fingers is electrically connected to the same collection finger; a connecting member, the connecting member being located on the cells, the connecting member being electrically connected to the plurality of fingers arranged along the second direction, and the connecting member being welded to each of the welding fingers.

In some embodiments, a width of the welding fingers along the second direction is greater than or equal to a width of the collection fingers along the second direction.

In some embodiments, the welding fingers include a first type of fingers and a second type of fingers, the first type of fingers and the collection fingers are made of a burn-through paste, and the second type of fingers are made of a non-burn-through paste.

In some embodiments, the welding fingers include: a first sub-finger and a second sub-finger which are stacked, the second sub-finger is located between the connecting member and the first sub-finger, and materials of the first sub-finger and the second sub-finger are different.

In some embodiments, the cells are back-contact cells, the fingers include first fingers of a first conductivity type and second fingers of a second conductivity type, the first fingers include first welding fingers corresponding to a first welding region and first collection fingers corresponding to a first collection region, the second fingers include second welding fingers corresponding to a second welding region and second collection fingers corresponding to a second collection region, the first welding region and the second collection region are directly opposite to each other along the second direction, and the second welding region and the first collection region are directly opposite to each other along the second direction; the photovoltaic module further including: an insulating layer, the insulating layer being located between the connecting member and the second collection fingers.

In some embodiments, the insulating layer is located on the first fingers and the second fingers, and a region of the insulating layer corresponding to the first welding region exposes the first welding fingers.

In some embodiments, at least two of the first welding fingers of the same first finger contact each other to form a welding pad, and a width of the welding pad along the second direction is greater than a width of the first collection finger along the second direction.

In some embodiments, in a region corresponding to the connecting member, a top surface of the first welding finger close to the insulating layer is higher than a top surface of the first welding finger far from the insulating layer.

In some embodiments, a distance between the insulating layer and the first welding finger is proportional to a thickness of the insulating layer.

In some embodiments, along the second direction and toward the first welding finger, a thickness of the insulating layer decreases.

In some embodiments, the second collection fingers include two broken fingers and a break located between the two broken fingers, the break corresponds to the first welding region, the broken fingers are located on both sides of the connecting member and are insulated from the connecting member.

### BRIEF DESCRIPTION OF THE DRAWINGS

One or more embodiments are illustratively described through the figures in the corresponding drawings. These illustrative descriptions do not limit the embodiments, and unless otherwise stated, the figures in the drawings do not constitute scale limitations. To more clearly describe the technical solutions in the embodiments of the present disclosure or in the conventional technology, the drawings required for describing the embodiments would be briefly introduced below. Obviously, the drawings in the following description are only some embodiments of the present disclosure. For those of ordinary skill in the art, other drawings can be obtained based on these drawings without creative effort.
FIG. 1 is a schematic structural diagram of a photovoltaic module according to embodiments of the present disclosure.
FIG. 2 is a top view of a photovoltaic module according to embodiments of the present disclosure.
FIG. 3 is a partial cross-sectional view of FIG. 2.
FIG. 4 shows four schematic diagrams of welding fingers in a photovoltaic module according to embodiments of the present disclosure.
FIG. 5 is a top view of welding fingers in a photovoltaic module according to embodiments of the present disclosure.
FIG. 6 is a partial cross-sectional view of a photovoltaic module according to embodiments of the present disclosure.
FIG. 7 is another top view of welding fingers in a photovoltaic module according to embodiments of the present disclosure.
FIG. 8 is a cross-sectional view corresponding to FIG. 7.
FIG. 9 is a schematic structural diagram of a photovoltaic module according to another embodiment of the present disclosure.
FIG. 10 is a top view of a photovoltaic module according to another embodiment of the present disclosure.
FIG. 11 is another top view of a photovoltaic module according to another embodiment of the present disclosure.
FIG. 12 is a partial cross-sectional view of FIG. 11.
FIG.13 is another partial cross-sectional view of FIG. 11.
FIG.14 is a partial top view of a photovoltaic module according to another embodiment of the present disclosure.

### DETAILED DESCRIPTION OF THE EMBODIMENTS

As known from the background part, current photovoltaic modules have relatively high power generation losses.

Analysis reveals that one reason for the current power generation losses is: mainstream silver electrodes are a combination of silver and glass frit, with a loose and unstable structure. Coupled with different melting points of mainstream silver electrodes compared to copper ribbons, if 0BB technology is adopted, the single-point welding area is reduced by 90%. When subjected to external force or thermal expansion and contraction, the ribbons are prone to detach from the cells, causing power generation losses.

The embodiments of this disclosure provide a photovoltaic module. By arranging welding fingers, and welding a plurality of welding fingers to a connecting member, the welding area between the connecting member and the cells is increased, which is beneficial for improving the welding pull force. Thereby, situations such as pseudo soldering of the connecting member and detachment of the connecting member from the cells can be avoided, which is beneficial for improving the yield of the photovoltaic module and the cell efficiency of the photovoltaic module.

In the description of the embodiments of this disclosure, technical terms such as "first", "second", and the like, are used only to distinguish different objects and cannot be understood as indicating or implying relative importance or implicitly specifying the quantity, the specific order, or primary-secondary relationship of the indicated technical features. In the description of the embodiments of this disclosure, the meaning of "a plurality of" is two or more, unless explicitly and specifically defined otherwise.

Mention of "embodiment" in this document means that specific features, structures, or characteristics described in combination with the embodiment may be included in at least one embodiment of this disclosure. The appearance of this phrase in various places in the specification does not necessarily always refer to the same embodiment, nor is it an independent or alternative embodiment mutually exclusive with other embodiments. Those skilled in the art explicitly and implicitly understand that the embodiments described herein can be combined with other embodiments.

In the description of the embodiments of this disclosure, the term "and/or" is merely a descriptive association relationship of associated objects, indicating that three relationships may exist. For example, A and/or B may indicate: existence of A alone, simultaneous existence of A and B, and existence of B alone. Furthermore, the character "/" in this text generally indicates that the associated objects before and after the character "/" are in an "or" relationship.

In the description of the embodiments of this disclosure, the term "a plurality of" refers to two or more (including two). Similarly, "a plurality of groups" refers to two or more groups (including two groups), and "a plurality of pieces" refers to two or more pieces (including two pieces).

In the description of the embodiments of this disclosure, technical terms such as "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", and the like, indicate the orientation or positional relationship based on the orientation or positional relationship shown in the drawings, and are only for the convenience of describing the embodiments of this disclosure and simplifying the description, rather than indicating or implying that the referred device or element must have a specific orientation, be constructed and operated in a specific orientation, and therefore cannot be understood as a limitation to the embodiments of this disclosure.

In the description of the embodiments of this disclosure, unless otherwise explicitly specified and defined, technical terms such as "install", "connect", "join", "fix", and the like, should be understood broadly. For example, it may be a fixed connection, a detachable connection, or integrated into one; it may be a mechanical connection, an electrical connection; it may be a direct connection, or an indirect connection through an intermediary, or it may be the internal communication between two elements or the interaction relationship between two elements. Those of ordinary skill in the art can understand the specific meanings of the above terms in the embodiments of this disclosure according to specific situations.

In the drawings corresponding to the embodiments of this disclosure, for better understanding and ease of description, the thicknesses and areas of layers are exaggerated. When describing that a component (such as a layer, a film, a region, or a substrate) is on or above another component, the component may be "directly" on the surface of the other component, or there may be an intermediate component between the two components. Conversely, when describing that a component is on the surface of another component or that another component is formed directly on or provided on the surface of a component, it means that there is no intermediate component between the two components. Furthermore, when describing that a component is " approximately " formed on another component, it means that the component is not formed on the entire surface (or front surface) of the other component, nor is it formed on part of the edge of the entire surface of the other component.

In the description of the embodiments of this disclosure, when a component "includes" another component, unless otherwise stated, it does not exclude other components, and other components may also be included. Furthermore, when a component such as a layer, a film, a region, or a plate is described as being "on/located on" another component, it may be "directly on" the other component (i.e., located on the surface of the other component with no other component in between), or there may be another component in between. Furthermore, when a component such as a layer, a film, a region, or a plate is "directly located on" another component, or when a component such as a layer, a film, a region, or a plate is located on the surface of another component, it means that no other component is located in between.

The terminology used in the description of the various described embodiments herein is for the purpose of describing specific embodiments only and is not intended to be limiting. As used in the description of the various embodiments and the appended claims, the singular forms "a", "an", and "the" are intended to include the plural forms as well, unless the context clearly indicates otherwise. Wherein, components include layers, films, regions, plates, and other components.

The various embodiments of this disclosure would be described in detail below with reference to the accompanying drawings. However, those of ordinary skill in the art can understand that in the various embodiments of this disclosure, many technical details are proposed to enable the reader to better understand this disclosure. However, even without these technical details and various changes and modifications based on the following embodiments, the technical solutions claimed in this disclosure can be realized.

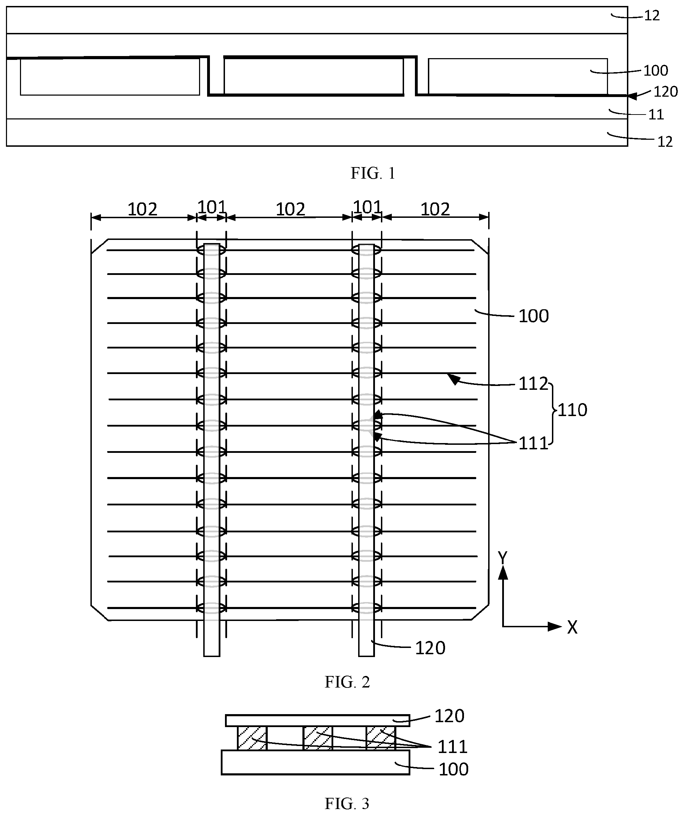

FIG. 1 is a schematic structural diagram of a photovoltaic module according to embodiments of this disclosure; FIG. 2 is a top view of a photovoltaic module according to embodiments of this disclosure; FIG. 3 is a partial cross-sectional view of FIG. 2. Among them, the connecting member in FIG. 2 is shown in a semi-perspective state, and the adhesive film and the cover plate are shown in a perspective state, meaning that the welding fingers under the connecting member can be seen through the connecting member. The cross-sectional view in FIG. 3 does not show the adhesive film and the cover plate; in reality, the gap between the two welding fingers is filled with an adhesive film.

The embodiments of this disclosure provide a photovoltaic module, used to reduce power generation loss. Referring to FIG. 1 and FIG. 2, the photovoltaic module includes: cells 100, each cell 100 include welding regions 101 and collection regions 102 alternately arranged along a first direction X and has a surface. The welding regions 101 includes a first region. each cell 100 includes a plurality of rows of fingers 110 disposed on the surface and arranged at intervals along a second direction Y, fingers 110 in each row includes at least two welding fingers 111 located in the first welding region 101 and a collection fingers 112 located in a collection region 102 adjacent to the first welding region, where the at least two welding fingers 111 are arranged along the second direction Y, and are electrically connected to the collection finger 112. The photovoltaic module further includes: a connecting member 120, located on the surface in the first region, electrically connected to the plurality of fingers 110, and welded to the at least two welding finger 111.

The photovoltaic module provided by the embodiments of this disclosure, the surface of the cells 100 includes a plurality of fingers 110 arranged along the second direction Y and connecting members 120. The connecting members 120 are welded to each welding finger 111. Through the welding connection between the welding fingers 111 and the connecting members 120, the number of welding fingers 111 is large, that is, a large number of welding points are formed between each cell 100 and the corresponding connecting member 120, thereby enhancing the welding pull strength, preventing detachment of connecting members 120 from cell 100, and avoiding issues such as poor Electroluminescence (EL) appearance and power generation loss caused by false welding. One collection finger 112 is electrically connected to a plurality of welding fingers 111. In this way, the fingers on the cells can be connected to the connecting members 120 through a plurality of paths, effectively avoiding power generation loss caused by broken fingers.

In some embodiments, the cells 100 may include, but is not limited to, any one of Passivated Emitter Rear (PERC) cells, Passivated Emitter and Rear Totally-diffused (PERT) cells, Tunnel Oxide Passivated Contact (TOPCon)cells, and Heterojunction Technology (HIT/HJT) cells .

In some embodiments, each of the cells 100 may be a monocrystalline silicon solar cell, a polycrystalline silicon solar cell, an amorphous silicon solar cell, or a multi-compound solar cell. The multi-compound solar cell may specifically be a cadmium sulfide solar cell, a gallium arsenide solar cell, a copper indium selenide solar cell, or a perovskite solar cell.

In some embodiments, each of the cells 100 is a full-size cell or a cut cell. A cut cell refers to a cell piece formed by a cutting process from a complete full-size cell. The cutting process includes: Laser Scribing and Cleaving (LSC) process and Thermal Mechanical Cleaving (TMC) process.

In some embodiments, the cut cell is a half-cell, which can also be understood as a half-cut cell or a bisected cell. The function of the half-cut cell module is to improve the generated power by reducing resistance loss. The half-cut cell module can optimize a width of each connecting member 120 in the cell. Conventionally, a balance needs to be optimized between increasing the width of the connecting member 120 to reduce power generation loss and reducing the width of each connecting member 120 to reduce shading loss. The half-cut cell module reduces cell loss, so the width of each connecting member 120 can be set thinner to reduce shading loss, which is beneficial for improving cell efficiency and generated power. In other embodiments, the cut cell may be a tri-section cell, a 4-section cell, or an 8-section cell, etc.

The welding regions 101 refer to the region where each of the connecting members 120 is welded to the cells. To ensure that the area contacted by each connecting member 120 is entirely within a corresponding welding region 101, the area of the welding region 101 is generally set to be larger than the area of the connecting member 120. Therefore, the width of each connecting member 120 shown in FIG. 2 is smaller than the width of corresponding welding region 101.

The collection regions 102 refer to the area on the cells other than the welding regions 101, used for collecting and summarizing current.

It should be noted that the welding fingers 111, at least two of which disposed in correspondence with a respective welding region 101, not only serve to form an alloy contact with the connecting members 120 but also serve to collect and summarize current.

The welding fingers 111 are used to form an alloy contact with the connecting members 120, thereby achieving the purpose of welding. The alloy contact between the welding fingers 111 and the connecting members 120, two welding fingers 112 joined to one connecting member 120, can be formed through a welding process or a lamination process.

In some embodiments, the width of each of the welding fingers 111 is equal to the width of each of the collection fingers 112. In this way, the shading area of the welding fingers 111 can be reduced, thereby improving the photoelectric conversion efficiency of the cells.

In other embodiments, the width of each of the welding fingers 111 is greater than the width of each of the collection fingers 112. Setting a larger width for each of the welding fingers 111 results in a larger contact area between each of connecting members 120 and corresponding welding fingers 111, thereby improving the performance of the alloy contact between the connecting members 120 and the welding fingers 111, further improving the welding quality, and avoiding problems such as virtual welding and power generation loss caused by the detachment of the connecting members 120 from the cells. Secondly, with a larger width of the welding fingers 111, the probability of the welding fingers 111 breaking due to thermal expansion and contraction of the tin layer on the connecting member 120 during the welding process is reduced, thereby improving poor EL appearance and reducing power generation loss.

In some embodiments, the number of welding fingers 111 can be 2 to 5. A larger number of welding fingers 111 means a larger number of welding points between the connecting members 120 and the cells, thereby improving the welding quality between the cells and the connecting members 120.

For example, the number of welding fingers 111 can be 2, 3, 4, or 5.

In some embodiments, the shape of the welding fingers 111 can be any one of arc-shaped, straight-line-shaped, polyline-shaped, or wave-shaped.

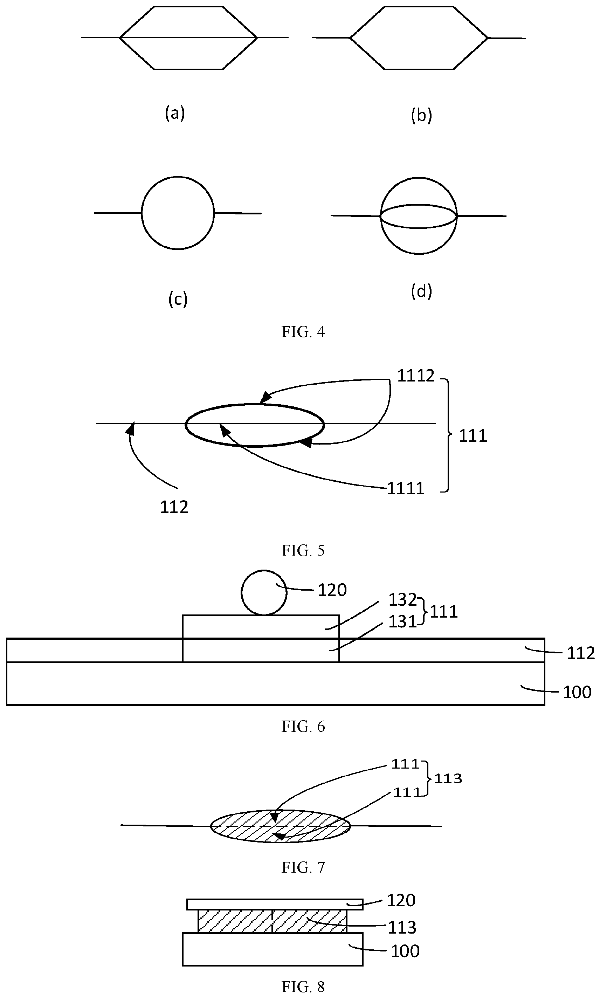

FIG. 4 shows four schematic diagrams of welding fingers in a photovoltaic module according to embodiments of this disclosure.

Referring to FIG. 4, the number and shape of the welding fingers can be any one of those shown in FIG. 4 (a~d), which are not limited in the embodiments of this disclosure.

A width range of each welding finger and a spacing range between each welding finger are not limited in this disclosure, and those skilled in the art can set them according to actual needs.

FIG. 5 is a top view of welding fingers in a photovoltaic module according to embodiments of this disclosure.

Referring to FIG. 5, in some embodiments, the welding fingers 111 include a first type of fingers 1111 and a second type of fingers 1112. The first type of fingers 1111 and the collection fingers 112 are made of a burn-through paste, and the second type of fingers 1112 is made of a non-burn-through paste. In this way, the first type of fingers 1111 is used to collect carriers and weld with the connecting members 120. The second type of finger 1112 is used for welding with the connecting members 120 and has good welding pull force, thereby achieving high welding quality and low power generation losses.

Among them, burn-through paste refers to an electrode paste that can burn through the passivation layer of the cells and electrically connect with the doped layer, for example, the welding fingers are electrically connected to the emitter. Non-burn-through paste refers to an electrode paste that cannot burn through the passivation layer.

It should be noted that the first type of fingers 1111 and the collection fingers 112 can be integrally formed fingers. The first type of fingers 1111 and the collection fingers 112 can be printed in the same printing process, and then the second type of fingers 1112 can be printed in another printing process. In some embodiments, the first type of fingers, the collection finger, and the second type of fingers can also be printed separately.

FIG. 6 is a partial cross-sectional view of a photovoltaic module according to embodiments of this disclosure.

In some embodiments, referring to FIG. 6, each of the welding fingers 111 include: a first sub-finger 131 and a second sub-finger 132. Each second sub-finger 132 is located between corresponding connecting member 120 and first sub-finger 131. The materials of each first sub-finger 131 and each second sub-finger 132 are different. By arranging the first sub-fingers 131 and second sub-fingers 132 which are stacked with different materials, the first sub-fingers 131 may be set to burn through the passivation layer and contact the doped layer, thereby collecting carriers and achieving high photoelectric conversion efficiency; while the second sub-fingers 132 located on the first sub-fingers 131 are used for welding with the connecting members 120. The compatibility between the second sub-fingers 132 and the connecting member 120 in the molten state is good, thus achieving good welding quality and high welding pull force, avoiding the power generation loss problem caused by the detachment of the connecting members 120 from the cells 100.

For example, the material of the first sub-finger 131 can be silver-aluminum, and the material of the second sub-finger 132 can be silver. For another example, the material of the first sub-finger 131 is silver-aluminum, and the material of the second sub-finger 132 is solder paste.

It should be noted that the height of the first sub-finger 131 in FIG. 6 being consistent with the height of the collection fingers 112 is only schematic. In reality, the surface of the first sub-finger 131 can be lower than the surface of the collection fingers 112, flush with the surface of the first sub-finger 131, or even the height of the first sub-finger 131 can be higher than the height of the collection fingers 112.

FIG. 7 is another top view of welding fingers in a photovoltaic module according to an embodiment of this disclosure; FIG. 8 is a cross-sectional view corresponding to FIG. 7.

In some embodiments, at least two welding fingers 111 of the same first finger contact each other to form a welding pad 113. A width of the welding pad 113 along the second direction is greater than the width of the collection fingers 112 along the second direction. In this way, the electrical connection with the connecting member 120 is achieved through the welding pad 113. Compared with a single finger, the welding pad 113 has a larger width, thereby avoiding problems of broken fingers and insufficient welding pull force, and improving welding quality.

Furthermore, compared with multiple welding fingers 111, the welding pad 113 has a larger operational window, thereby reducing the process difficulty of the cells and improving accuracy and precision, thus improving the yield and aesthetics of the photovoltaic module.

The connecting members 120 are used to achieve mutual connection between cells 100 and to collect current for transmission to components outside the photovoltaic module. Each connecting member 120 includes bus bars and interconnect ribbons. Bus bars are used to connect the photovoltaic cell string and the junction box. Interconnect ribbons are used to connect between the first cell and the second cell.

In some embodiments, each connecting member 120 has a core-shell structure. Each connecting member 120 includes a conductive layer and a solder layer covering the surface of the conductive layer. The conductive layers are the main conductive transmission layers of the connecting members 120. Therefore, the lower the resistivity of the conductive layers, the smaller the electrical loss of the connecting members 120, and the better the cell efficiency and generated power. The material of each conductive layer is a conductive material with good conductivity such as copper, nickel, gold, silver, and the like, or an alloy material with low resistivity.

In some embodiments, each of the solder layers may be plated or coated on the surface of a corresponding conductive layer. Specifically, special processes such as electroplating, vacuum deposition, spraying, or hot dipping can be used to uniformly cover and coat the source material of the solder layer around the conductive layers according to a certain composition ratio and thickness. The main function of the solder layers is to make the connecting members 120 solderable and to firmly weld the connecting members 120 to the finger structures of the cells 100, playing a good role in current conduction.

In some embodiments, the material of each solder layer is a metal material or an alloy material with a melting point lower than that of the conductive layer, such as a tin alloy. The tin alloy may include tin-zinc alloy, tin-bismuth alloy, or tin-indium alloy. Welding with tin as the solder material has the advantage of low melting point, good affinity with metals like copper, and good welding strength. Lead in tin-lead alloy can lower the melting point of the ribbons. Tin and lead can form a eutectic point with a melting point of 183°C, and have good soldering performance and usability.

The disclosed embodiments of this disclosure use other metal elements to replace lead or add other elements to the tin-lead alloy, such as bismuth. The use of bismuth can lower the melting temperature and reduce surface tension. The melting point of tin-bismuth alloy can drop to 129°C, meeting needs of low-temperature soldering. In this way, the thermal expansion and contraction stress of the connecting member 120 is smaller, reducing a risk and a probability of broken welding fingers 111.

In some embodiments, the solder layer contains flux. Flux refers to a chemical substance that can help and promote the soldering process during soldering, while having a protective effect and preventing oxidation reactions. Flux includes inorganic flux, organic flux, and resin flux. It can be understood that the melting point of the flux is lower than that of the solder layer, and the flux increases the fluidity of the molten solder layer, so that the solder layer and the finger structure form a good alloy.

In some embodiments, along a cross-section perpendicular to the first direction Y, the cross-sectional shape of each connecting member 120 is circular. Circular ribbons do not have orientation or alignment issues, and are easier to mass-produce.

In some embodiments, the cross-sectional shape of each connecting member 120 can be triangular or any other shape to increase the contact area between the ribbons and the finger structure and reduce the problem of misalignment between each connecting member 120 and corresponding finger structure.

In some embodiments, the surface of each connecting member 120 away from the cells has a reflective layer. Each reflective layer is located on the outer side of the solder layer away from corresponding conductive layer and cells. The reflective layers are used to improve the electrical loss caused by the shading area of the connecting members 120 on the cells.

In some embodiments, the outer surface of the solder layer has reflective grooves. The reflective grooves are grooves or trenches recessed from the solder layer towards the conductive layer. Sunlight is reflected onto the cells through the sidewalls of the reflective grooves, improving the utilization rate of sunlight.

In some embodiments, continuing to refer to FIG. 1, the photovoltaic module further includes a cell string. The cell string is composed of a plurality of the cells described in the above embodiments through the connecting members 120, where each connecting member 120 is used to connect adjacent cells 100 in series.

In some embodiments, the cells include a first cell and a second cell. each connecting member 120 connects the first electrode of the first cell and the second electrode of the second solar cell adjacent to the first cell, or each connecting member 120 connects the second electrode of the first cell and the first electrode of the second cell adjacent to the first cell. Among them, the first electrode is one of the positive electrodes or the negative electrodes, and the second electrode is the other of the positive electrodes or the negative electrodes.

In some embodiments, referring to FIG. 1, front sides of both the first cell and the second cell face the same side, and back sides of both the first cell and the second cell face the same side. In other words, the first electrodes of all cells 100 face the same side, and the second electrodes of all cells 100 face the same side. Then the connecting members 120 need to naturally extend from the front side of one cell to the back side of the adjacent cell, so that each connecting member 120 connects the first electrode of one cell and the second electrode of the adjacent cell.

In other embodiments, the first cell and the second cell are arranged in the order of first surface, second surface, first surface, and second surface. Then the connecting members do not bend, and each connecting member directly connects the first electrode of the first cell and the second electrode of the second cell adjacent to the first cell.

Among them, the adjacent cells 100 shown in FIG. 1 have cell gaps between the adjacent cells 100 to achieve electrical insulation between different cells 100. In other embodiments, there are no cell gaps between adjacent cells, meaning the cells are arranged in a stacked manner.

Continuing to refer to FIG. 1, the photovoltaic module further includes: an adhesive film 11 covering the surface of the cell string and filling the gaps between the cell strings. The photovoltaic module further includes: a cover plate 12 covering the side of the adhesive film 11 away from the cell string.

The material of the adhesive film 11 includes EVA, POE, PVB, or other organic encapsulation adhesive films.

In some embodiments, the glass transition temperature of the adhesive film 11 is -70~-10°C. The glass transition temperature of the adhesive film is used to ensure that the adhesive film can be in a molten state during the lamination process, to fill various gaps of the photovoltaic module and improve the yield of the photovoltaic module.

In some embodiments, the melting point of the adhesive film and the melting point of the connecting members 120 may be set according to actual needs. When the melting point of the adhesive film 11 is greater than the melting point of the connecting members 120, the connecting member 120 can achieve alloying before the adhesive film 11 becomes molten, which can effectively prevent the molten adhesive film 11 from penetrating into the welding fingers 111 and the connecting members 120 and pushing the connecting members 120 to cause offset. When the melting point of the adhesive film 11 is less than the melting point of the connecting members 120, the lamination temperature can be set lower, thereby improving the thermal stress on the cells 100 and improving the yield of the photovoltaic module.

In some embodiments, the cover plate 12 can be a glass cover plate, a plastic cover plate, or other cover plates with light-transmitting function. Specifically, the surface of the cover plate 12 away from the adhesive film 11 can be an uneven surface to increase the utilization rate of incident light. The cover plate 12 includes a first cover plate and a second cover plate. The first cover plate is opposite to the front side of the cells, and the second cover plate is opposite to the back side of the cells.

In the photovoltaic module provided by the embodiment of this disclosure, the surface of the cells includes a plurality of fingers arranged along the second direction and connecting members 120, each connecting member 120 is welded to a corresponding welding finger 111. Through the welding connection between the welding fingers 111 and the connecting members 120, the number of welding fingers 111 is large, that is, the number of welding points between the cells and the connecting members 120 is large, thereby improving the welding pull force between the cells and the connecting member 120, avoiding the problem of the connecting members 120 detaching from the cells, and avoiding the problems of poor EL appearance and power generation loss caused by virtual welding. One collection finger 112 is electrically connected to multiple welding fingers 111. In this way, the fingers on the cells can be connected to the connecting members 120 through multiple paths, effectively avoiding power generation loss caused by broken fingers.

Correspondingly, another embodiment of this disclosure also provides a cell. The difference from the above embodiment is that the cell in the above embodiment is a non-back-contact cell, meaning one side of the cell has fingers of one conductivity type. However, another embodiment of this disclosure provides a back-contact cell, where one side of the solar cell has first fingers of a first conductivity type and second fingers of a second conductivity type. The same or corresponding parts as the above embodiment are not described in detail here.

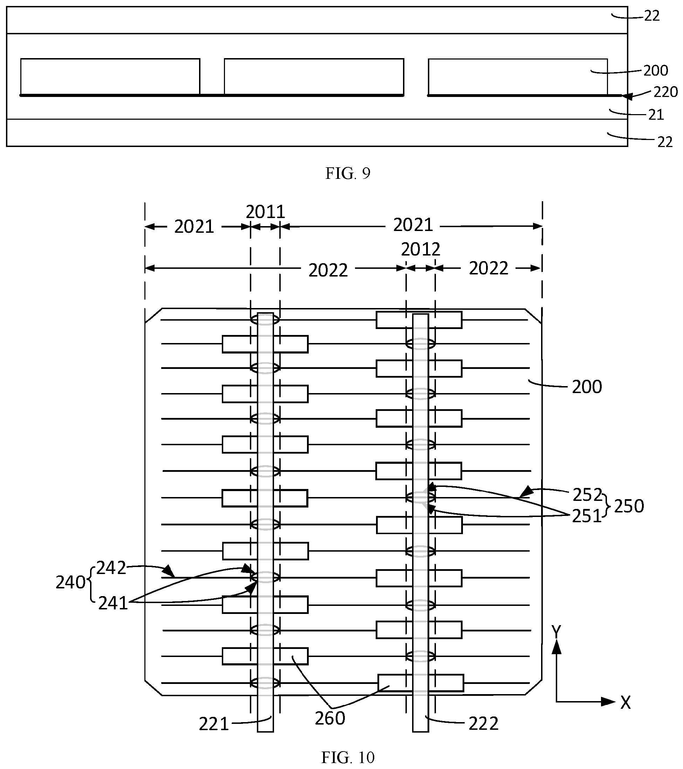

FIG. 9 is a schematic structural diagram of a photovoltaic module according to another embodiment of this disclosure; FIG. 10 is a top view of a photovoltaic module according to another embodiment of this disclosure.

Another embodiment of this disclosure provides a photovoltaic module, used to reduce power generation loss. Referring to FIG. 9 and FIG. 10, the photovoltaic module includes: cells 200, the cells 200 include welding regions and collection regions arranged along a first direction X.

In some embodiments, the cells 200 are a back-contact cell, such as an Interdigitated back contact (IBC) solar cell. An IBC cell refers to a back-junction back-contact solar cell structure where the positive and negative metal electrodes are arranged in an interdigitated pattern on the backlight surface of the cells. The PN junction and electrodes of the IBC cell are located on the back side of of the IBC cell, meaning the electrodes of both the emitter region and the base region of the IBC cell are on the back side of the IBC cell, and there is no finger shading on the front side of the IBC cell, which can improve the photoelectric conversion performance of the cells.

Referring to FIG. 10, each welding regions may include a first welding region 2011 and a second welding region 2012, and each collection regions may include a first collection region 2021 and a second collection region 2022.

The surface of the cells 200 has a plurality of fingers arranged along a second direction. Each finger includes at least two welding fingers located in the welding regions and a collection finger located in the collection regions, where the welding fingers are arranged along the second direction, and each of the at least two welding fingers is electrically connected to the same collection finger.

In some embodiments, referring to FIG. 10, the fingers include first fingers 240 of a first conductivity type and second fingers 250 of a second conductivity type. The first fingers 240 include first welding fingers 241 corresponding to the first welding region 2011 and first collection fingers 242 corresponding to the first collection region. The second fingers 250 include second welding fingers 251 corresponding to the second welding region 2012 and second collection fingers 252 corresponding to the second collection region 2022. The first welding region 2011 and the second collection region 2022 are directly opposite to each other along the second direction Y. The second welding region 2012 and the first collection region 2021 are directly opposite to each other along the second direction Y.

Referring to FIG. 10, the photovoltaic module includes: connecting member located on the cells. Each connecting member includes a first connecting member 221 and a second connecting member 222. Each first connecting member 221 is electrically connected to a plurality of first fingers 240 arranged along the second direction Y, and each first connecting member 221 is welded to a corresponding first welding finger 241. Each second connecting member 222 is electrically connected to a plurality of second fingers 250 arranged along the second direction Y, and each second connecting member 222 is welded to each second welding finger 251.

Continuing to refer to FIG. 10, the photovoltaic module further includes insulating layers 260. Each insulating layer 260 is located between each of the first connecting member 221 and the second collection fingers 252, between each of the second connecting member 222 and the first collection fingers 242.

In some embodiments, the insulating layers 260 are independent adhesive blocks, corresponding to the area between each first connecting member 221 and the second collection fingers 252 and between each second connecting member 222 and the first collection fingers 242, thereby reducing the amount of insulating layer 260 used and lowering preparation costs.

The dimensions, length, thickness and other parameters of the insulating layer 260 in this embodiment are not limited in this disclosure, as long as the parameters ensure electrical insulation between each first connecting member 221 and the second collection fingers 252 and between each second connecting member 222 and the first collection fingers 242 which correspond to each other.

In some embodiments, each insulating layer 260 not only covers one first welding region 2011 but also extends beyond the first welding region 2011 to part of the width of one first collection region 2021. The width extending into the first collection region 2021 is 0.5mm~2.5mm. In this way, the difficulty of string soldering is reduced, and the risk of short circuit is effectively avoided.

For example, the width of each insulating layer 260 extending into one first collection region 2021 is 0.5mm, 0.8mm, 1.0mm, 1.2mm, 1.4mm, 1.6mm, 1.8mm, 2.0mm, 2.2mm, 2.4mm, or 2.5mm.

Similarly, each insulating layer 260 not only covers one second welding region 2012 but also extends into one second collection region 2022, and the extended width is 0.5mm~2.5mm.

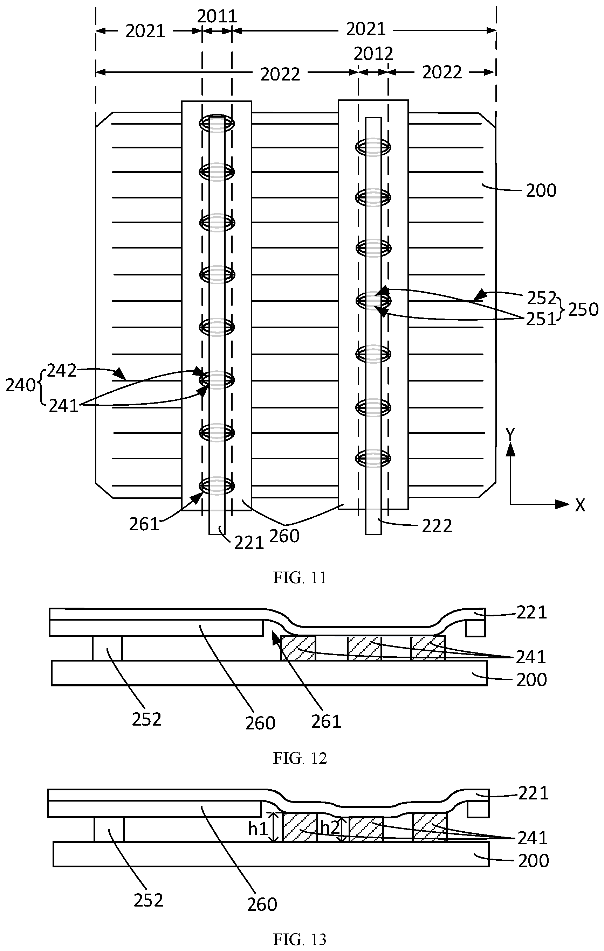

FIG. 11 is another top view of a photovoltaic module according to another embodiment of this disclosure; FIG. 12 is a partial cross-sectional view of FIG. 11; FIG. 13 is another partial cross-sectional view of FIG. 11.

In some embodiments, referring to FIG. 11, the insulating layer 260 is located on the first fingers 240 and the second fingers 250. The insulating layer 260 has hollowed-out regions 261. The hollowed-out regions 261 correspond to the first welding region 2011 and expose the first welding fingers 241. The hollowed-out regions also correspond to the second welding region 2012 and expose the second welding fingers 251. In this way, a whole insulating layer 260 is set, and hollowed-out regions 261 are set in the corresponding areas to achieve electrical connection between the first connecting member 221 and the first welding fingers 241, and between the second connecting member 222 and the second welding fingers 251. This reduces the difficulty of printing individual insulating layer blocks and the requirement for alignment accuracy, thereby reducing process difficulty.

In some embodiments, the portion of insulating layer 260 covers the first welding regions 2011 and extends beyond the first welding regions 2011 to part of the width of the first collection regions 2021. The width extending into the first collection region 2021 is 0.5mm~2.5mm; another portion of insulating layer 260 covers the second welding region 2012 and extends beyond the second welding region 2012 to part of the width of the second collection region 2022. The width extending into the second collection region 2022 is 0.5mm~2.5mm. In this way, the difficulty of string soldering is reduced, and the risk of short circuit is effectively avoided.

In some embodiments, at least two first welding fingers 241 of the same first finger 240 contact each other to form a welding pad. The width of the welding pad along the second direction is greater than the width of the first collection finger 242 along the second direction Y. In this way, the electrical connection with the connecting member is achieved through the welding pad. Compared with a single finger, the welding pad has a larger width, thereby avoiding problems of broken fingers and insufficient welding pull force, and improving welding quality. Furthermore, compared with multiple welding fingers, the welding pad has a larger operational window, thereby reducing the process difficulty of the cells and improving accuracy and precision, thus improving the yield and aesthetics of the photovoltaic module.

Similarly, in some embodiments, at least two second welding fingers 251 of the same second finger 250 contact each other to form a welding pad. The width of the welding pad along the second direction is greater than the width of the second collection finger 252 along the second direction Y.

In some embodiments, referring to FIG. 13, in the region corresponding to the connecting member, a top surface of first welding fingers 241 close to the insulating layer 260 is higher than a top surface of the first welding fingers 241 far from the insulating layer 260, that is, a height h1 of each first welding finger 241 close to the insulating layer 260 can be greater than a height h2 of each first welding finger 241 far from the insulating layer 260. From FIG. 12 and FIG. 13, it can be seen that because the height h1 of the first welding fingers 241 close to the insulating layer 260 is slightly higher, a contact area between the first connecting member 221 and the top surface of the first welding fingers 241 close to the insulating layer 260 becomes larger, thereby improving welding quality and increasing welding pull force.

In some embodiments, the width of each first welding fingers 241 close to the insulating layer 260 can be greater than the width of the first welding finger 241 far from the insulating layer 260.

In some embodiments, a distance between the insulating layer 260 and the first welding fingers 241 is proportional to a thickness of the insulating layer 260. That is, when the thickness of the insulating layer 260 is larger, the distance between the insulating layer 260 and the first welding fingers 241 is larger, and an area of the hollowed-out region is larger, so that the first connecting member 221 has more space to deform and the contact area between the connecting member and the first welding fingers 241 is larger. Conversely, when the thickness of the insulating layer 260 is smaller, the distance between the insulating layer 260 and the first welding fingers 241 is smaller, and the area of the hollowed-out region is smaller.

In some embodiments, along the second direction Y and towards the first welding finger 241, the thickness of the insulating layer 260 decreases. In this way, the first connecting members 221 may be welded to the first welding fingers 241 along a changing trend of the thickness of the insulating layer 260, thereby increasing the welding area and avoiding virtual welding problems.

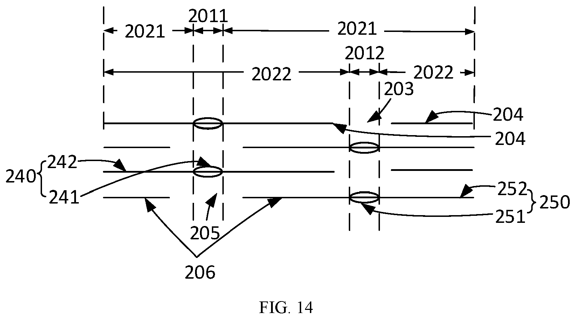

FIG. 14 is a partial top view of a photovoltaic module according to another embodiment of this disclosure.

In some embodiments, each first collection finger 242 includes two first broken fingers 206 and a first break 205 located between the two first broken fingers 206. The first break 205 corresponds to the second welding region 2012. The first broken fingers 206 are located on both sides of the second connecting member and are insulated from the second connecting member.

Each second collection finger 252 includes two broken fingers 204 and a break 203 located between the two broken fingers 204. The break 203 corresponds to the first welding region 2011. The broken fingers 204 are located on both sides of the first connecting member and are insulated from the first connecting member.

In some embodiments, continuing to refer to FIG. 9, the photovoltaic module further includes a cell string. The cell string is composed of a plurality of the cells described in the above embodiments through the connecting member, where the connecting member is used to connect adjacent cells in series.

In some embodiments, the cells include a first cell and a second cell. Each connecting member 220 connects the first welding fingers 241 of the first cell and the second welding fingers 251 of the second solar cell adjacent to the first cell, or each connecting member 220 connects the second welding fingers 251 of the first cell and the first welding fingers 241 of the second solar cell adjacent to the first cell.

Continuing to refer to FIG. 9, the photovoltaic module further includes: an adhesive film 21 covering the surface of the cell string and filling the gaps between the cell strings. The photovoltaic module further includes: a cover plate 22 covering the side of the adhesive film 21 away from the cell string.

In the photovoltaic module provided by the embodiment of this disclosure, the surface of the cells includes a plurality of first fingers 240 and second fingers 250 arranged along the second direction, first connecting members 221, and second connecting members 222. Each first connecting member 221 is welded to corresponding first welding fingers 241, and each second connecting member 222 is electrically connected to corresponding second welding fingers 251. Through the electrical connection between the first welding fingers 241 and the first connecting member 221 and the welding connection between the second welding fingers 251 and the second connecting member 222, the number of first welding fingers 241 and second welding fingers 251 is large, that is, the number of welding points between the cells and the first connecting members 221 and between the cells and the second connecting members 222 is large, thereby improving the welding pull force between the cells and the connecting members, avoiding the problem of the connecting members detaching from the cells, and avoiding the problems of poor EL appearance and power generation loss caused by virtual welding. Each first collection finger 242 is electrically connected to a plurality of first welding fingers 241. In this way, the first fingers on the cells can be connected to the first connecting members 221 through a plurality of paths, effectively avoiding power generation loss caused by broken fingers.

Those of ordinary skill in the art can understand that the above various embodiments are specific embodiments for implementing this disclosure. In practical applications, various changes can be made in form and details without departing from the scope of this disclosure. Any person skilled in the art can make various changes and modifications without departing from the scope of this disclosure. Therefore, the protection scope of this disclosure shall be defined by the claims.

## Claims

1. A photovoltaic module, comprising:
solar cells, a respective cell of the solar cells including welding regions and collection regions alternately arranged along a first direction;
a plurality of rows of fingers, arranged at intervals along a second direction, fingers in a row including at least two welding fingers located in the first welding region and a collection finger located in the first collection region, wherein the at least two welding fingers are arranged along the second direction, and a respective welding finger of the at least two welding fingers is electrically connected to the collection finger of the same row;
a connecting member disposed on the respective cell, electrically connected to at least some of the plurality of fingers, and welded to the at least two welding fingers.

2. The photovoltaic module according to claim 1, wherein a width of the respective welding finger along the second direction is greater than or equal to a width of the collection finger along the second direction.

3. The photovoltaic module according to claim 1, wherein the respective welding finger includes a first type of fingers and a second type of fingers, where the first type of fingers and the collection finger are made of a burn-through paste, and the second type of fingers are made of a non-burn-through paste.

4. The photovoltaic module according to claim 1 or 3, wherein the respective welding finger includes: a first sub-finger and a second sub-finger which are stacked, the second sub-finger is located between the connecting member and the first sub-finger, and materials of the first sub-finger and the second sub-finger are different.

5. The photovoltaic module according to claim 1, wherein the cells are back-contact cells, the plurality of rows of fingers include first fingers of a first conductivity type and second fingers of a second conductivity type, the first fingers include first welding fingers corresponding to the first welding region and first collection fingers corresponding to the first collection region, the second fingers include second welding fingers corresponding to a second welding region and second collection fingers corresponding to a second collection region, the first welding region and the second collection region are directly opposite to each other along the second direction, and the second welding region and the first collection region are directly opposite to each other along the second direction; the photovoltaic module further includes: an insulating layer, the insulating layer being located between the connecting member and the second collection fingers.

6. The photovoltaic module according to claim 5, wherein the insulating layer is located on the first fingers and the second fingers, extends in the second direction, and is provided with hollowed-out regions configured to expose the first welding fingers.

7. The photovoltaic module according to claim 5 or 6, wherein at least two of the first welding fingers of the same first finger contact each other to form a welding pad, and a width of the welding pad along the second direction is greater than a width of the first collection finger along the second direction.

8. The photovoltaic module according to claim 5 or 6, wherein, in a region corresponding to each of the connecting member, a top surface of the first welding finger close to the insulating layer is higher than a top surface of the first welding finger far from the insulating layer.

9. The photovoltaic module according to claim 6, wherein a distance between the insulating layer and the first welding fingers is proportional to a thickness of the insulating layer.

10. The photovoltaic module according to claim 6, wherein, along the second direction and toward the first welding fingers, a thickness of the insulating layer decreases.

11. The photovoltaic module according to claim 6, wherein each of the second collection fingers comprises two broken fingers and a break located between the two broken fingers, the break corresponds to the first welding region, the broken fingers are located on both sides of a respective connecting member and are insulated from the respective connecting member.
